# EUROPEAN PATENT SPECIFICATION

(11) **EP 0 632 086 B1**
(45) Date of publication and mention of the grant of the patent: **06.10.1999**
(21) Application number: 94304431.3
(22) Date of filing: 17.06.1994
(51) Int. Cl.: C08G 77/60

(54) **A method of producing a semiconducting material**
Verfahren zur Herstellung eines Halbleitermaterials
Procédé de préparation d'un matériau semiconducteur

(30) Priority: 18.06.1993 JP 17235893
(43) Date of publication of application: 04.01.1995
(73) Proprietor: NIPPON OIL CO., LTD., Tokyo (JP)
(72) Inventor: Ikai, Keizo, Yokohama-shi, Kanagawa-ken (JP); Matsuno, Mitsuo, Yokohama-shi, Kanagawa-ken (JP); Minami, Masaki, Yokohama-shi, Kanagawa-ken (JP)
(74) Representative: Bridge-Butler, Alan James

(56) References cited:
- EP-A- 0 264 722
- EP-A- 0 282 037
- EP-A- 0 445 306
- DATABASE WPI Derwent Publications Ltd., London, GB; AN 93-080486 & JP-A-05 015 281 (NIPPON TELEGRAPH & TELEPHONE CORP.) , 2 February 1993
- DATABASE WPI Derwent Publications Ltd., London, GB; AN 93-080487 & JP-A-05 028 282 (NIPPON TELEPHONE & TELEGRAPH) , 2 February 1993

## Description

This invention relates to a method of producing a semiconducting material for use in the formation of diodes, transistors, field effect transistors, thyristors and like semiconductor elements.

A gas-phase crystal growth procedure has found extensive use in the production of thin films of amorphous silicone or compound semiconductors in which their low molecular weight feedstock in gaseous phase is thermally decomposed or chemically reacted in high vacuum to deposit on a substrate. This method however would involve prohibitive costs to reduce to practice for making large semiconductor films because there will be required large-scale vacuum devices on one hand and there is a limitation imposed upon the rate of film deposition on the other.

With the foregoing drawbacks of the prior art in view, the present invention seeks to provide an improved method of producing semiconducting materials at a maximum rate of efficiency and a minimum of costs.

JP-A-05 025 281 describes a process for producing an organo-silicon polymer useful for forming SiC precursors. The process involves subjecting methylphenyldichlorosilane and n-butyltrichlorosilane to a desalting reaction by the action of metallic sodium. JP-A-05 025 282 is directed to a similar process to that described in JP-A-05 025 281 the difference lying in the reactants used in the process; methylphenyldichlorosilane and phenyltrichlorosilane.

DE-A-4 110 917 discloses a thermal treatment for producing silicon carbide from a polysilane. The described process is concerned with the use of certain metals as catalysts using temperatures in excess of 800 degrees Celcius.

EP-A-0 445 306 discloses the reaction of halosilanes with alkali metals at 100°C to prepare a polysilane composition useful as an organic semi-conductor.

According to the invention there is provided a method of producing a semiconducting material which is characterized by reacting one or more halogenosilanes of the group consisting of :
halogenomonosilanes of the formula 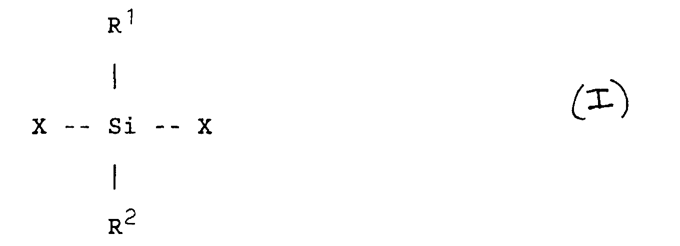 wherein R¹ and R² are independently selected from the group consisting of X, secondary alkyl, tertiary alkyl and cycloalkyl groups having from 3 to 12 carbon atoms, primary, secondary and tertiary aralkyl groups having from 8 to 12 carbon atoms and silyl groups having the formula:

R³ R⁴ R⁵ Si-- (I')

wherein R³, R⁴ and R⁵ are independently selectd from the group consisting of alkyl groups having up to 8 carbon atoms and aryl groups having from 6 to 10 carbon atoms and X which is chlorine, bromine or iodine,
halogenodisilanes having the formula: 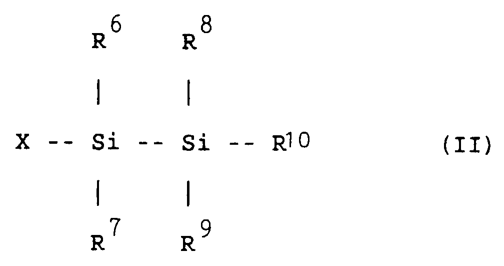 wherein R⁶ to R¹⁰ are independently selected from the group consisting of X, secondary alkyl, tertiary alkyl and cycloalkyl groups having from 3 to 12 carbon atoms, primary, secondary and tertiary aralkyl groups having from 8 to 12 carbon atoms, said silyl groups (I') and X is chlorine, bromine or iodine, and at least one of R⁶ to R¹⁰ is X,
and halogenotrisilanes having the formula: 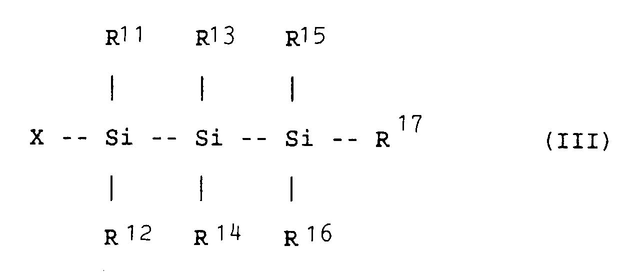 wherein R¹¹ to R¹⁷ are independently selected from the group consisting of X, secondary alkyl, tertiary alkyl and cycloalkyl groups having from 3 to 12 carbon atoms, primary, secondary and tertiary aralkyl groups having from 8 to 12 carbon atoms, said silyl groups (I') and X is chlorine, bromine or iodine, and at least one of R¹¹ to R¹⁷ is X,
with an alkali metal and/or alkaline earth metal to give a condensate, and thermally decomposing said condensate at a temperature of 100 to 700 degrees Celsius.

The term halogenomonosilane of the formula (I) according to the invention preferably includes tetrachlorosilane, i-propyltrichlorosilane, t-butyltrichlorosilane, (1-methylpropyl)trichlorosilane, cyclohexyltrichlorosilane, (1,1,2-trimethylpropyl)trichlorosilane, α-phenethyltrichlorosilane, cumenyltrichlorosilane, (trimethylsilyl)trichlorosilane, di-i-propyldichlorosilane, di-t-butyldichlorosilane, di(1-methylpropyl)dichlorosilane, dicyclohexyldichlorosilane, di-α-phenethyldichlorosilane and bis(trimethylsilyl)dichlorosilane, and further includes tetrabromosilane, i-propyltribromosilane, t-butyltribromosilane, (1-methylpropyl)tribromosilane, cyclohexyltribromosilane, (1,1,2-trimethylpropyl)tribromosilane, α-phenethyltribromosilane, cumenyltribromosilane, (trimethylsilyl)tribromosilane, di-i-propyldibromosilane, di-t-butyldibromosilane, di(1-methylpropyl)dibromosilane, dicyclohexyldibromosilane, di-α-phenethyldibromosilane, bis(trimethylsilyl)dibromosilane, tetraiodosilane, i-propyltriiodosilane, t-butyltriiodosilane, (1-methylpropyl)triiodosilane, cyclohexyltriiodosilane, (1,1,2-trimethylpropyl)triiodosilane, α-phenethyltriiodosilane, cumenyltriiodosilane, (trimethylsilyl)triiodosilane, di-i-propyldiiodosilane, di-t-butyldiiodosilane, di(1-methylpropyl)diiodosilane, dicyclohexyldiiodosilane, di-α-phenethyldiiodosilane and bis(trimethylsilyl)diiodosilane.

Halogenodisilanes of the formula (II) preferably include hexachlorodisilane, i-propylpentachlorodisilane, t-butylpentachlorodisilane, (1-methylpropyl)pentachlorodisilane, cyclohexylpentachlorodisilane, (1,1,2-trimethylpropyl)pentachlorodisilane, α-phenethylpentachlorodisilane, cumenylpentachlorodisilane, (trimethylsilyl)pentachlorodisilane, 1,1-di-i-propyltetrachlorodisilane, 1,1-di-t-butyltetrachlorodisilane, 1,1-di(1-methylpropyl)tetrachlorodisilane, 1,1-dicyclohexyltetrachlorodisilane, 1,1-di-α-phenethyltetrachlorodisilane, 1,1-bis(trimethyloilyl)tetrachlorodisilane, 1,2-di-i-propyltetrachlorodisilane, 1,2-di-t-butyltetrachlorodisilane, 1,2-di(1-methylpropyl)tetrachlorodisilane, 1,2-dicylohexyltetrachlorodisilane, 1,2-di-α-phenethyltetrachlorodisilane and 1,2-bis(trimethylsilyl)tetrachlorodisilane. They further include 1,1,1-tri-i-propyltrichlorodisilane, 1,1,1-tri-t-butyltrichlorodisilane, 1,1,1-tri(1-methylpropyl)trichlorodisilane, 1,1-tricyclohexyltrichlorodisilane, 1,1,1-tri-α-phenethyltrichlorodisilane, 1,1,1-tris(trimethylsilyl)trichlorodisilane, 1,1,2-tri-i-propyltrichlorodisilane, 1,1,2-tri-t-butyltrichlorodisilane, 1,1,2-tri(1-methylpropyl)trichlorodisilane, 1,1,2-tricyclohexyltrichlorodisilane, 1,1,2-tri-α-phenethyltrichlorodisilane, 1,1,2-tris(trimethylsilyl)trichlorodisilane, hexabromodisilane, i-propylpentabromodisilane, t-butylpentabromodisilane, (1-methylpropyl)pentabromodisilane, cyclohexylpentabromodisilane, (1,1,2-trimethylpropyl)pentabromodisilane, α-phenethylpentabromodisilane, cumenylpentabromodisilane, (trimethylsilyl)pentabromodisilane, 1,1-di-i-propyltetrabromodisilane, 1,1-di-t-butyltetrabromodisilane, 1,1-di(1-methylpropyl)tetrabromodisilane, 1,1-dicyclohexyltetrabromodisilane, 1,1-di-α-phenethyltetrabromodisilane, 1,1-bis(trimethyisiiyl)tetrabromodisilane, 1,2-di-i-propyltetrabromodisilane, 1,2-di-t-butyltetrabromodisilane, 1,2-di(1-methylpropyl)tetrabromodisilane, 1,2-dicyclohexyltetrabromodisilane, 1,2-di-α-phenethyltetrabromodisilane, 1,2-bis(trimethylsilyl)tetrabromodisilane, 1,1,1-tri-i-propyltribromodisilane, 1,1,1-tri-t-butyltribromodisilane, 1,1,1-tri(1-methylpropyl)tribromodisilane, 1,1,1-tricyclohexyltribromodisilane, 1,1,1-tri-α-phenethyltribromodisilane, 1,1,1-tris(trimethylsilyl)tribromodisilane, 1,1,2-tri-i-propyltribromodisilane, 1,1,2-tri-t-butyltribromodisilane, 1,1,2-tri(1-methylpropyl)tribromodisilane, 1,1,2-tricyclohexyltribromodisilane, 1,1,2-tri-α-phenethyltribromodisilane, 1,1,2-tris(trimethylsilyl)tribromodisilane, hexaiododisilane, i-propylpentaiododisilane, t-butylpentaiododisilane, (1-methylpropyl)pentaiododisilane, cyclohexylpentaiododisilane, (1,1,2-triemthylpropyl)pentaiododisilane, α-phenethylpentaiododisilane, cumenylpentaiododisilane, (trimethylsilyl)pentaiododisilane, 1,1-di-i-propyltetraiododisilane, 1,1-di-t-butyltetraiododisilane, 1,1-di(1-methylpropyl)tetraiododisilane, 1,1-dicyclohexyltetraiododisilane, 1,1-di-α-phenethyltetraiododisilane, 1,1-bis(trimethylsilyl)tetraiododisilane, 1,2-di-i-propyltetraiododisilane, 1,2-di-t-butyltetraiododisilane, 1,2-di(1-methylpropyl)tetraiododisilane, 1,2-dicyclohexyltetraiododisilane, 1,2-di-α-phenethyltetraiododisilane, 1,2-bis(trimethylsilyl)tetraiododisilane, 1,1,1-tri-i-propyltriiododisilane, 1,1,1-tri-t-butyltriiododislane, 1,1,1-tri(1-methylpropyl)triiododisilane, 1,1,1-tricyclohexyltriiododisilane, 1,1,1-tri-α-phenethyltriiododisilane, 1,1,1-tris(trimethylsilyl)triiododisilane, 1,1,2-tri-i-propyltriiododisilane, 1,1,2-tri-t-butyltriiododisilane, 1,1,2-tri(1-methylpropyl)triiododisilane, 1,1,2-tricyclohexyltriiododisilane, 1,1,2-tri-α-phenethyltriiododisilane and 1,1,2-tris(trimethylsilyl)triiododisilane.

Halogenotrisilanes of the formula (III) preferably include octachlorotrisilane, 1-i-propylheptachlorotrisilane, 1-t-butylheptachlorotrisilane, 1-(1-methylpropyl)heptachlorotrisilane, 1-cyclohexylheptachlorotrisilane, 1-(1,1,2-trimethylpropyl)heptachlorotrisilane, 1-α-phenethylheptachlorotrisilane, 1-cumenylheptachlorotrisilane, 1-(trimethylsilyl)heptachlorotrisilane, 2-i-propylheptachlorotrisilane, 2-t-butylheptachlorotrisilane, 2-(1-methylpropyl)heptachlorotrisilane, 2-cyclohexylheptachlorotrisilane, 2-(1,1,2-trimethylpropyl)heptachlorotrisilane, 2-α-phenethylheptachlorotrisilane, 2-cumenylheptachlorotrisilane, 2-(trimethylsilyl)heptachlorotrisilane, 1,1-di-i-propylhexachlorotrisilane, 1,1-di-t-butylhexachlorotrisilane, 1,1-di(1-methylpropyl)hexachlorotrisilane, 1,1-dicyclohexylhexachlorotrisilane, 1,1-di-α-phenethylhexachlorotrisilane, 1,1-bis(trimetylsilyl)hexachlorotrisilane, 1,2-di-i-propylhexachlorotrisilane, 1,2-di-t-butylhexachlorotrisilane, 1,2-di(1-methylpropyl)hexachlorotrisilane, 1,2-dicyclohexylhexachlorotrisilane, 1,2-di-α-phenethylhexachlorotrisilane, 1,2-bis(trimethylsilyl)hexachlorotrisilane, 1,3-di-i-propylhexachlorotrisilane, 1,3-di-t-butylhexachlorotrisilane, 1,3-di(1-methylpropyl)hexachlorotrisilane, 1,3-dicyclohexylhexachlorotrisilane, 1,3-di-α-phenethylhexachlorotrisilane, 1,3-bis(trimethylsilyl)hexachlorotrisilane, 1,1,1-tri-i-propylpentachlorotrisilane, 1,1,1-tri-t-butylpentachlorotrisilane, 1,1,1-tri(1-methylpropyl)pentachlorotrisilane, 1,1,1-tricyclohexylpentachlorotrisilane, 1,1,1-tri-α-phenethylpentachlorotrisilane, 1,1,1-tris(trimethylsilyl)pentachlorotrisilane, 1,1,2-tri-i-propylpentachlorotrisilane, 1,1,2-tri-t-butylpentachlorotrisilane, 1,1,2-tri(1-methylpropyl)pentachlorotrisilane, 1,1,2-tricyclohexylpentachlorotrisilane, 1,1,2-tri-α-phenethylpentachlorotrisilane, 1,1,2-tris(trimethylsilyl)pentachlorotrisilane, 1,2,3-tri-i-propylpentachlorotrisilane, 1,2,3-tri-t-butylpentachlorotrisilane, 1,2,3-tri(1-methylpropyl)pentachlorotrisilane, 1,2,3-tricyclohexylpentachlorotrisilane, 1,2,3-tri-α-phenethylpentachlorotrisilane and 1,2,3-tris(trimethylsilyl)pentachlorotrisilane.

Examples of other halogenotrisilanes eligible for the purpose of the invention include octabromotrisilane, 1-i-propylheptabromotrisilane, 1-t-butylheptabromotrisilane, 1-(1-methylpropyl)heptabromotrisilane, 1-cyclohexylheptabromotrisilane, 1-(1,1,2-trimethylpropyl)heptabromotrisilane, 1-α-phenethylheptabromotrisilane, 1-cumenylheptabromotrisilane, 1-(trimethylsilyl)heptabromotrisilane, 2-i-propylheptabromotrisilane, 2-t-butylheptabromotrisilane, 2-(1-methylpropyl)heptabromotrilane, 2-cyclohexylheptabromotrisilane, 2-(1,1,2-trimethylpropyl)heptabromotrisilane, 2-α-phenethylheptabromotrisilane, 2-cumenylheptabromotrisilane, 2-(trimethylsilyl)heptabromotrisilane, 1,1-di-i-propylhexabromotrisilane, 1,1-di-t-butylhexabromotrisilane, 1,1-di(1-methylpropyl)hexabromotrisilane, 1,1-dicyclohexylhexabromotrisilane, 1,1-di-α-phenethylhexabromotrisilane, 1,1-bis(triemthylsilyl)hexabromotrisilane, 1,2-di-i-propylhexabromotrisilane, 1,2-di-t-butylhexabromotrisilane, 1,2-di(1-methylpropyl)hexabromotrisilane, 1,2-dicyclohexylbromotrisilane, 1,2-di-α-phenethylhexabromotrisilane, 1,2-bis(trimethylsilyl)hexabromotrisilane, 1,3-di-i-propylhexabromotrisilane, 1,3-di-t-butylhexabromotrisilane, 1,3-di(1-methylpropyl)hexabromotrisilane, 1,3-dicyclohexylhexabromotrisilane, 1,3-di-α-phenethylhexabromotrisilane, 1,3-bis(trimethylsilyl)hexabromotrisilane, 1,1,1-tri-i-propylpentabromotrisilane, 1,1,1-tri-t-butylpentabromotrisilane, 1,1,1-tri(1-methylpropyl)pentabromotrisilane, 1,1,1-tricyclohexylpentabromotrisilane, 1,1,1-tri-α-phenethylpentabromotrisilane, 1,1,1-tris(trimethylsilyl)pentabromotrisilane, 1,1,2-tri-i-propylpentabromotrisilane, 1,1,2-tri-t-butylpentabromotrisilane, 1,1,2-tri(1-methylpropyl)pentabromotrisilane, 1,1,2-tricyclohexylpentabromotrisilane, 1,1,2-tri-α-phenethylpentabromotrisilane, 1,1,2-tris(trimethylsilyl)pentabromotrisilane, 1,2,3-tri-i-propylpentabromotrisilane, 1,2,3-tri-t-butylpentabromotrisilane, 1,2,3-tri(1-methylpropyl)pentabromotrisilane, 1,2,3-tricyclohexylpentabromotrisilane, 1,2,3-tri-α-phenethylpentabromotrisilane, 1,2,3-tris(trimethylsilyl)pentabromotrisilane, octaiodotrisilane, 1-i-propylheptaiodotrisilane, 1-t-butylheptaiodotrisilane, 1-(1-methylpropyl)heptaiodotrisilane, 1-cyclohexylheptaiodotrisilane, 1-(1,1,2-trimethylpropyl)heptaiodotrisilane, 1-α-phenethylheptaiodotrisilane, 1-cumenylheptaiodotrisilane, 1-(trimethylsilyl)heptaiodotrisilane, 2-i-propylheptaiodotrisilane, 2-t-butylheptaiodotrisilane, 2-(1-methylpropyl)heptaiodotrisilane, 2-cyclohexylheptaiodotrisilane, 2-(1,1,2-trimethylpropyl)heptaiodotrisilane, 2-α-phenethylheptaiodotrisilane, 2-cumenylheptaiodotrisilane, 2-(trimethylsilyl)heptaiodotrisilane, 1,1-di-i-propylhexaiodotrisilane, 1,1-di-t-butylhexaiodotrisilane, 1,1-di(1-methylpropyl)hexaiodotrisilane, 1,1-dicyclohexylhexaiodotrisilane, 1,1-di-α-phenethylhexaiodotrisilane, 1,1-bis(trimethylsilyl)hexaiodotrisilane, 1,2-di-i-propylhexaiodotrisilane, 1,2-di-t-butylhexaiodotrisilane, 1,2-di(1-methylpropyl)hexaiodotrisilane, 1,2-dicyclohexylhexaiodotrisilane, 1,2-di-α-phenethylhexaiodotrisilane, 1,2-bis(trimethylsilyl)hexaiodotrisilane, 1,3-di-i-propylhexaiodotrisilane, 1,3-di-t-butylhexaiodotrisilane, 1,3-di(1-methylpropyl)hexaiodotrisilane, 1,3-dicyclohexylhexaiodotrisilane, 1,3-di-α-phenethylhexaiodotrisilane, 1,3-bis(trimethylsilyl)hexaiodotrisilane, 1,1,1-tri-i-propylpentaiodotrisilane, 1,1,1-tri-t-butylpentaiodotrisilane, 1,1,1-tri(1-methylpropyl)pentaiodotrisilane, 1,1,1-tricyclohexylpentaiodotrisilane, 1,1,1-tri-α-phenethylpentaiodotrisilane, 1,1,1-tris(trimethylsilyl)pentaiodotrisilane, 1,1,2-tri-i-propylpentaiodotrisilane, 1,1,2-tri-t-butylpentaiodotrisilane, 1,1,2-tri(1-methylpropyl)pentaiodotrisilane, 1,1,2-tricyclohexylpentaiodotrisilane, 1,1,2-tri-α-phenethylpentaiodotrisilane, 1,1,2-tris(trimethylsilyl)pentaiodotrisilane, 1,2,3-tri-i-propylpentaiodotrisilane, 1,2,3-tri-t-butylpentaiodotrisilane, 1,2,3-tri(1-methylpropyl)pentaiodotrisilane, 1,2,3-tricyclohexylpentaiodotrisilane, 1,2,3-tri-α-phenethylpentaiodotrisilane and 1,2,3-tris(trimethylsilyl)pentaiodotrisilane.

The above exemplified halogenosilane compounds are reacted with an alkali metal and/or an alkaline earth metal usually in an inert solvent. This reaction is known as Wurtz condensation reaction.

The term inert solvent used in the invention includes a hydrocarbon solvent such as toluene, xylene, heptane, decane and dodecane, and an ether solvent such as diethyl ether, isopropyl ether, methylbutylether, dimethoxy ethane, tetrahydrofuran and dioxane. Theee solvents may be used singly or in combination.

The solvent is used in an amount of usually 1-100 parts by volume, preferably 5-50 parts by volume per part by volume of the halogenosilane compound.

Examples of the alkali metal with which the halogenosilane is reacted include lithium, potassium, sodium, and examples of the alkaline earth metal include magnesium and calcium. These metals may be used singly or in combination. The amount of such a metal to be 1 used is usually 1-100 mole, preferably 1-50 mols per mol of the halogenosilane compound.

The reaction is effected by introducing droplets of the halogenosilane compound into the inert solvent in which the metal is dispersed, or by introducing droplets of the metal dispersed solvent into the inert solvent in which the halogenosilane is dissolved. The reaction is conducted preferably in an argon or nitrogen gas atmosphere with or without ultrasonic irradiation. The reaction temperature is usually in the range of 0°-250°C, preferably 25°-210°C. The reaction pressure is usually in the range of atmospheric-200 kg/cm², preferably atmospheric-100 kg/cm². The reaction time is usually 5 minutes to 24 hours, preferably 30 minutes to 24 hours, though dependent upon the reaction temperature and the type of reaction metal used. The Wurtz condensation reaction may be carried out in the prensence of crown ethers such as 12-crown-4, 15-crown-5, 18-crown-6, dibenzo-12-crown-4, dibenzo-15-crown-5 and dibenzo-18-crown-6, or diamines such as tetramethylethylene-diamine. These additives may be used in an amount of usually 0.01-100 mols, preferably 0.01-50 mols per mol of the halogenosilane.

Upon completion of the reaction, the reaction system is added with an alcohol such as methanol and ethanol to render unreacted metals inert, followed by washing with water to remove NaCl and other by-products. The reaction solution is thereafter introduced into methanol, ethanol, IPA, ethyl acetate, pentane or hexane thereby allowing the resultant condensate to precipitate. The condensate may be otherwise refined by contact with Florisil (tradename). These processes may also be combined.

The condensate may be determined as to its structure by means of infrared or ultraviolet absorption spectrum, nuclear magnetic resonance (such as ¹HNMR, ¹³CNMR and ²⁹SiNMR) and gel permeation chromatography.

The condensate obtained in accordance with the invention usually contains repeating units of the 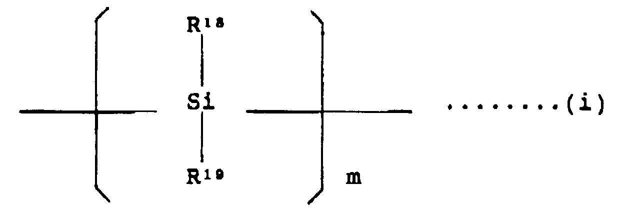 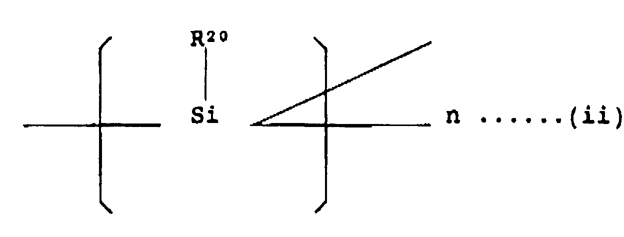 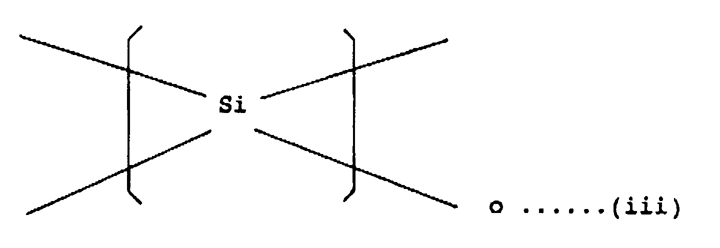 wherein R¹⁸, R¹⁹, and R²⁰ are identical or different, and each include C₃-C₁₂ secondary and tertiary alkyl and cycloalkyl groups, C₈-C₁₂ primary, secondary and tertiary aralkyl groups, the silyl groups (formula I'), and which is chlorine, bromine or iodine. The ratios of m, n and o may vary according to the type of the starting monomer, feedstock used and the relative amounts of two or more different halogenosilanes that may be used, The value n/m is usually 0-1,000, preferably 0-100, and the value o/n is usually 0-1,000, preferably 0-100.

The polysilane has a polymerization degree of usually 6-2,000 and a weight average molecular weight (Mw) of usually 100-10,000,000, preferably 500-1,000,000 and a number average molecular weight (Mn) of usually 100-1,000,000, preferably 300-500,000.

The condensate product is subjected to thermal decomposition in which it is dissolved in a suitable solvent such as toluene and tetrahydrofuran and cast over a sheet of quartz or stainless steel, or a silicon wafer.
Alternatively, the condensate may be thermally decomposed after it is processed into a fibrous or pellet form. The thermal decomposition is effected in the presence of an inert gas such as argon and nitrogen or in a vacuum of 10⁻⁵-10⁴ pa, preferably 10⁻³-10³ pa and at a temperature of 100°-700 °C, preferably 200°-700 °C. It may be effected in the presence of a reducing gas such as hydrogen or a mixture of this and the inert gas, in which case the reducing gas is used in an amount of 0.1-100%, preferably 1-50% relative to the inert gas. The thermal decomposition reaction may be further effected in the presence of a vapor such as of iodine, ferric chloride, antimony pentafluoride, antimony pentachloride, arsenic pentafluoride, phosphorus trichloride, boron tribromide and aluminum trichloride, the amount of addtion thereof being 1 vol.ppt- 10 vol.%, preferably 1 vol.ppb- 1 vol.%.

The semiconducting material derived from the inventive process ranges in hue from yellow to dark brown, to glossy silver and has in the case of a film a thickness of usually 0.01 µm - 500 µm, preferably 0.1 µm - 50 µm, and an optical band-gap (EO) of usually 0.1-4.0 eV, preferably 0.5-2.0 eV.

The invention will be further described by way of the following examples.

### Example 1

A 100 ml four-neck flask equipped with stirring blade, reflux condenser and funnel was charged with methallic sodium (1.4g., 40 mmols) and unhydrous toluene (20 mmols) and heated with stirring. When reflux began, a toluene solution (10 ml) of 1-methylpropyl-pentachlorodisilane (3.0 g., 10 mmols) was added dropwise under vigorous agitation. The reaction mixture immediately turned violet and subsequently, reflux with stirring continued for one hour, followed by cooling to room temperature and addition of methanol. The reaction mixture was thereafter added with ether (60 ml), washed with water and dried. The resulting condensate was refined by precipitation in toluene-methanol until there was obtained a yellowish powdery condensate product (0.29 g., yield 26%).

A toluene solution of the condensate was applied by casting to a sheet of quartz glass and then heated at 700°C for one hour in an argon atmosphere to give a dark brown film (0.1 µm thick). The film showed a conductivity of 10⁻⁶ S/cm and an optical band-gap (Eo) of 1.7 eV.

### Example 2

The procedure of Example 1 was followed except that a mixture of cyclohexyltrichlorosilane (2.2 g., 100 mmols) and silicon tetrachloride (0.85 g., 5.0 mmols) was used. There was obtained a yellowish powdery condensate (1.19 g., yield 19%).

A toluene solution of the condensate was applied by casting to a sheet of quartz glass and then heated at 700°C for one hour in an argon atmosphere to give a dark brown film (0.2 µm thick). The film showed a conductivity of 10⁻⁴ S/cm and an optical band-gap (Eo) of 1.5 eV.

### Example 3

The procedure of Example 1 was followed except that a mixture of 1,3-di-n-hexylhexa chlorotrisilane (0.8 g., 1.70 mmols), potassium-sodium alloy (0.84 g., 13.6 mmols) and 18-crown-6 (26 mg., 0.1 mmol) was used. There was obtained a yellowish powdery condensate (99 mg., yield 23%).

A toluene solution of the condensate was cast over a sheet of quartz glass and then heataed at 600°C for three hours in an argon atmosphere to give a dark brown film.
The film exhibited a conductivity of 10⁻⁶ S/cm and an optical band-gap (Eo) of 1.8 eV.

## Claims

1. A method of producing a semiconducting material which is characterized by reacting one or more halogenosilanes of the group consisting of :
halogenomonosilanes of the formula 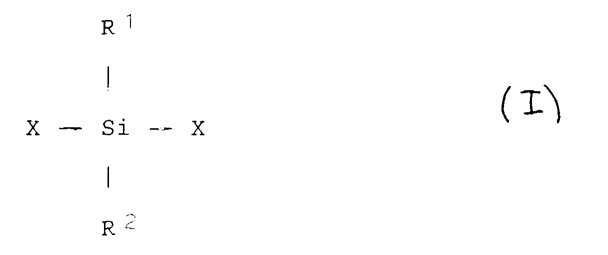 wherein R¹ and R² are independently selected from the group consisting of X, secondary alkyl, tertiary alkyl and cycloalkyl groups having from 3 to 12 carbon atoms, primary, secondary and tertiary aralkyl groups having from 8 to 12 carbon atoms and silyl groups having the formula:
R³ R⁴ R⁵ Si― (I')
wherein R³, R⁴ and R⁵ are independently selectd from the group consisting of alkyl groups having up to 8 carbon atoms and aryl groups having from 6 to 10 carbon atoms and X which is chlorine, bromine or iodine,
halogenodisilanes having the formula: 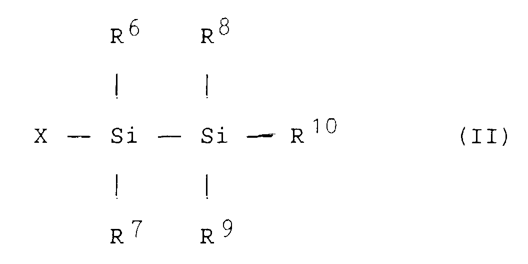 wherein R⁶ to R¹⁰ are independently selected from the group consisting of X, secondary alkyl, tertiary alkyl and cycloalkyl groups having from 3 to 12 carbon atoms, primary, secondary and tertiary aralkyl groups having from 8 to 12 carbon atoms, said silyl groups (I') and X is chlorine, bromine or iodine, and at least one of R⁶ to R¹⁰ is X,
and halogenotrisilanes having the formula: 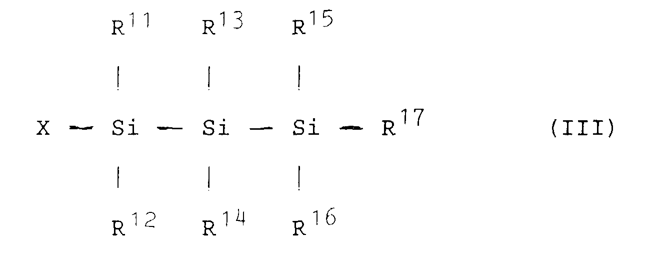 wherein R¹¹ to R¹⁷ are independently selected from the group consisting of X, secondary alkyl, tertiary alkyl and cycloalkyl groups having from 3 to 12 carbon atoms, primary, secondary and tertiary aralkyl groups having from 8 to 12 carbon atoms, said silyl groups (I') and X is chlorine, bromine or iodine, and at least one of R¹¹ to R¹⁷ is X,
with an alkali metal and/or alkaline earth metal to give a condensate, and thermally decomposing said condensate at a temperature of 100 to 700 degrees Celsius.

2. The method according to claim 1, characterized in that said semiconducting material has an optical band gap Eo in the range 0.1 to 2.0 eV.

3. The method according to claim 1 characterized in that the alkali metal is selected from the group of lithium, sodium and potassium, and said alkaline earth metal is selected from the group of calcium and magnesium, said alkali metal and/or said alkaline earth metal being used in an amount of 1 - 100 mols per mol of said halogenosilane.

4. The method according to claim 1 characterized in that the reaction is conducted in an inert solvent selected from the group consisting of toluene, xylene, heptane, decane, dodecane, diethyl ether, isopropyl ether, methylbutyl ether, dimethoxy ethane, tetrahydrofuran and dioxane, said inert solvent being used in an amount of 1 - 100 mols per mol of said halogenosilane.

5. The method according to claim 1 characterized in that the haloqenosilane is reacted with said alkali metal and/or said alkaline earth metal at a temperature of 0 to 250 degrees Celsius for a time length of 5 minutes to 24 hours.

6. The method according to claim 1 characterized in that the condensate is thermally decomposed in an inert gas atmosphere, or in a vacuum of 10⁻⁵ - 10⁴ Pa.

## Patentansprüche

1. Verfahren zur Herstellung eines Halbleitermaterials, **dadurch gekennzeichnet,** daß ein oder mehrere Halogensilane der Gruppe bestehend aus:
Halogenmonosilanen der Formel 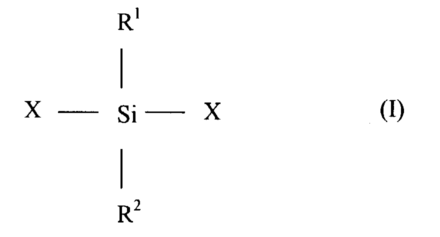 worin R¹ und R² unabhängig ausgewählt sind aus der Gruppe bestehend aus X, sekundären Alkyl, tertiären Alkyl und Cycloalkyl-Gruppen mit 3 bis 12 Kohlenstoffatomen, primären, sekundären und tertiären Aralkylgruppen mit 8 bis 12 Kohlenstoffatomen und Silylgruppen nach der Formel:
R³ R⁴ R⁵ Si ― (I')
worin R³ , R⁴ und R⁵ unabhängig ausgewählt sind aus der Gruppe bestehend aus Alkylgruppen mit bis zu 8 Kohlenstoffatomen und Arylgruppen mit 6 bis 10 Kohlenstoffatomen und X, welches Chlor, Brom, oder Jod ist, sowie Halogendisilane nach der Formel: 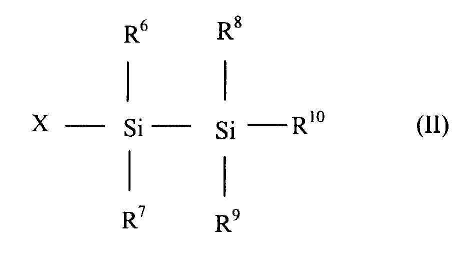 worin R⁶ bis R¹⁰ unabhängig ausgewählt sind aus der Gruppe bestehend aus X, sekundären Alkyl, tertiären Alkyl und Cycloalkyl-Gruppen mit 3 bis 12 Kohlenstoffatomen, primären, sekundären und tertiären Aralkylgruppen mit 8 bis 12 Kohlenstoffatomen und den Silyl-Gruppen (I') und X Chlor, Brom, oder Jod ist und mindestens eines der R⁶ bis R¹⁰ X ist, sowie Halogentrisilane nach der Formel: 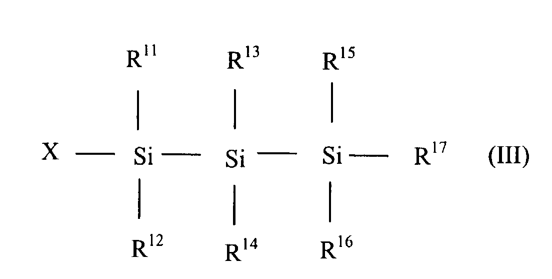 worin R¹¹ bis R¹⁷ unabhängig ausgewählt sind aus der Gruppe bestehend aus X, sekundären Alkyl, tertiären Alkyl und Cycloalkyl-Gruppen mit 3 bis 12 Kohlenstoffatomen, primären, sekundären und tertiären Aralkylgruppen mit 8 bis 12 Kohlenstoffatomen und den Silyl-Gruppen (I') und X Chlor, Brom, oder Jod ist und mindestens eines der R¹¹ bis R¹⁷ X ist, mit einem Alkalimetall und/oder Erdalkalimetall reagieren, um ein Kondensat zu bilden und dieses Kondensat thermisch bei einer Temperatur von 100 bis 700 Grad Celsius in seine Bestandteile zerlegt wird.

2. Verfahren nach Anspruch 1, **dadurch gekennzeichnet,** daß das Halbleitermaterial eine optische Bandlücke (Eo) im Bereich von 0,1 bis 2,0 eV aufweist.

3. Verfahren nach Anspruch 1, **dadurch gekennzeichnet,** daß das Alkalimetall aus der Gruppe ausgewählt wird, welche besteht aus Lithium, Natrium, Kalium und das Erdalkalimetall ausgewählt ist aus der Gruppe von Kalcium und Magnesium, und das Alkalimetall und/oder Erdalkalimetall in einer Menge von 1-100 Mol pro Mol des Halogensilans verwendet wird.

4. Verfahren nach Anspruch 1, **dadurch gekennzeichnet,** daß die Reaktion in einer Inert-Lösung ausgeführt wird, welche ausgewählt wird aus der Gruppe bestehend aus Toluene, Xylene, Heptane, Dekan, Dodekan, Diethyl-Ether, Methylbutyl-Ether, Dimethoxy-Ethan, Tetrahydrofuran, und Dioxan und die Inert-Lösung in einer Menge von 1 - 100 Mol pro Mol des Halogensilans verwendet wird.

5. Verfahren nach Anspruch 1, **dadurch gekennzeichnet,** daß das Halogensilan mit dem Alkalimetall und/oder dem Erdalkalimetall reagiert, bei einer Temperatur von 0 bis 250 Grad Celsius für eine Zeitspanne von 5 Minuten bis 24 Stunden.

6. Verfahren nach Anspruch 1, **dadurch gekennzeichnet,** daß das Kondensat thermisch zersetzt wird, in einer Inertgas-Atmosphäre oder unter Vakuum von 10⁻⁵ - 10⁴ Pa.

## Revendications

1. Procédé de préparation d'un matériau semi-conducteur, qui est caractérisé par la réaction d'un ou plusieurs halogénosilanes du groupe constitué par :
les halogénomonosilanes de formule 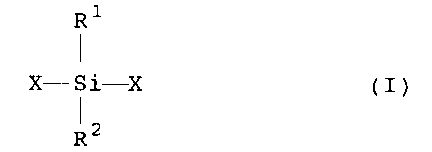 dans laquelle R¹ et R² sont indépendamment choisis dans le groupe constitué par X, les groupes alkyles secondaires, alkyles tertiaires et cycloalkyles ayant de 3 à 12 atomes de carbone, les groupes aralkyles primaires, secondaires et tertiaires ayant de 8 à 12 atomes de carbone et les groupes silyles ayant la formule :
R³ R⁴ R⁵Si- (I')
dans laquelle R³, R⁴ et R⁵ sont indépendamment choisis dans le groupe constitué par les groupes alkyles ayant jusqu'à 8 atomes de carbone et les groupes aryles ayant de 6 à 10 atomes de carbone et X est du chlore, du brome ou de l'iode,
les halogénodisilanes ayant la formule : 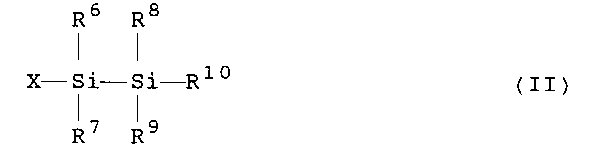 dans laquelle R⁶ à R¹⁰ sont indépendamment choisis dans le groupe constitué par X, les groupes alkyles secondaires, alkyles tertiaires et cycloalkyles ayant de 3 à 12 atomes de carbone, les groupes aralkyles primaires, secondaires et tertiaires ayant de 8 à 12 atomes de carbone, et lesdits groupes silyles (I'), et X est du chlore, du brome ou de l'iode, et au moins l'un parmi R⁶ à R¹⁰ est X,
et les halogénotrisilanes ayant la formule : 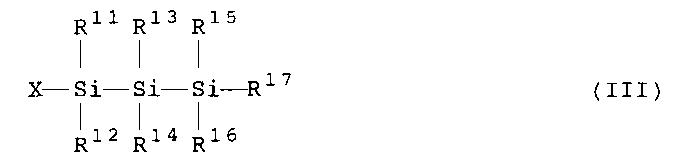 dans laquelle R¹¹ à R¹⁷ sont indépendamment choisis dans le groupe constitué par X, les groupes alkyles secondaires, alkyles tertiaires et cycloalkyles ayant de 3 à 12 atomes de carbone, les groupes aralkyles primaires, secondaires et tertiaires ayant de 8 à 12 atomes de carbone, et lesdits groupes silyles (I'), et X est du chlore, du brome ou de l'iode, et au moins l'un parmi R¹¹ à R¹⁷ est X,
avec un métal alcalin et/ou un métal alcalino-terreux, pour donner un condensat, et la décomposition thermique dudit condensat à une température de 100 à 700 °C.

2. Procédé selon la revendication 1, caractérisé en ce que ledit matériau semi-conducteur a une bande interdite optique EO dans la gamme de 0,1 à 2,0 eV.

3. Procédé selon la revendication 1, caractérisé en ce que le métal alcalin est choisi dans le groupe constitué par le lithium, le sodium et le potassium, et ledit métal alcalino-terreux est choisi dans le groupe constitué par le calcium et le magnésium, ledit métal alcalin et/ou ledit métal alcalino-terreux étant utilisé en une quantité de 1 à 100 moles par mole dudit halogénosilane.

4. Procédé selon la revendication 1, caractérisé en ce que la réaction est effectuée dans un solvant inerte choisi dans le groupe constitué par le toluène, le xylène, l'heptane, le décane, le dodécane, l'éther diéthylique, l'éther isopropylique, l'éther méthylbutylique, le diméthoxyéthane, le tétrahydrofuranne et le dioxane, ledit solvant inerte étant utilisé en une proportion de 1 à 100 moles par mole dudit halogénosilane.

5. Procédé selon la revendication 1, caractérisé en ce que l'halogénosilane est mis à réagir avec ledit métal alcalin et/ou ledit métal alcalino-terreux à une température de 0 à 250 °C pendant une durée de 5 minutes à 24 heures.

6. Procédé selon la revendication 1, caractérisé en ce que le condensat est décomposé thermiquement sous atmosphère de gaz inerte, ou sous un vide de 10⁻⁵ à 10⁴ Pa.
